# EUROPEAN PATENT APPLICATION

(11) **EP 1 591 797 A1**
(43) Date of publication of application: **02.11.2005**
(21) Application number: 04252469.4
(22) Date of filing: 28.04.2004
(51) Int. Cl.: G01R 31/327

(54) **Circuit breakers test device**

(71) Applicant: Megger Limited, Dover, Kent CT17 9EN (GB)
(72) Inventor: Haynes, Simon Michael, Ashford, Kent TN24 8JX (GB)
(74) Representative: Finnie, Peter John

(57) **Abstract**

According to the invention there is provided a device for testing an electric circuit, the electric circuit including a magnetic core (28) comprising means to generate an AC preconditioning signal with decaying amplitude;
means to apply the AC preconditioning signal to the magnetic element;
means to generate a test signal; and means to apply a test signal to the electric circuit, wherein the device is adapted to apply the test signal subsequent to the preconditioning signal.

The device may be a residual current circuit breaker (RCCB) trip time test instrument. Typically, RCCBs include a transformer core (20) onto which live (L) and neutral windings (N) are placed. Previous circuit activity can leave the transformer core (20) magnetised, even after the live and neutral currents have returned to an equal condition. This can affect subsequent tests. The device of the present invention applies a pre-conditioning decaying AC signal to the transformer core (20) in order to bring the residual magnetism to within a specified, acceptable level.

## Description

### Field of the Invention

The present invention relates to circuit breakers in electrical installations, and in particular to the pre-conditioning of a magnetic circuit within a residual current circuit breaker.

### Background to the Invention

Circuit breakers are used in electrical systems for safety reasons, in order to prevent accidents due to electrical shocks and to reduce possible fire hazards. One type of circuit breaker used for protection on AC mains supplies is a residual current circuit breaker (RCCB) which detects any imbalance in the current flow on the liveneutral loop. Any imbalance is usually due to a current flow between the live and earth.

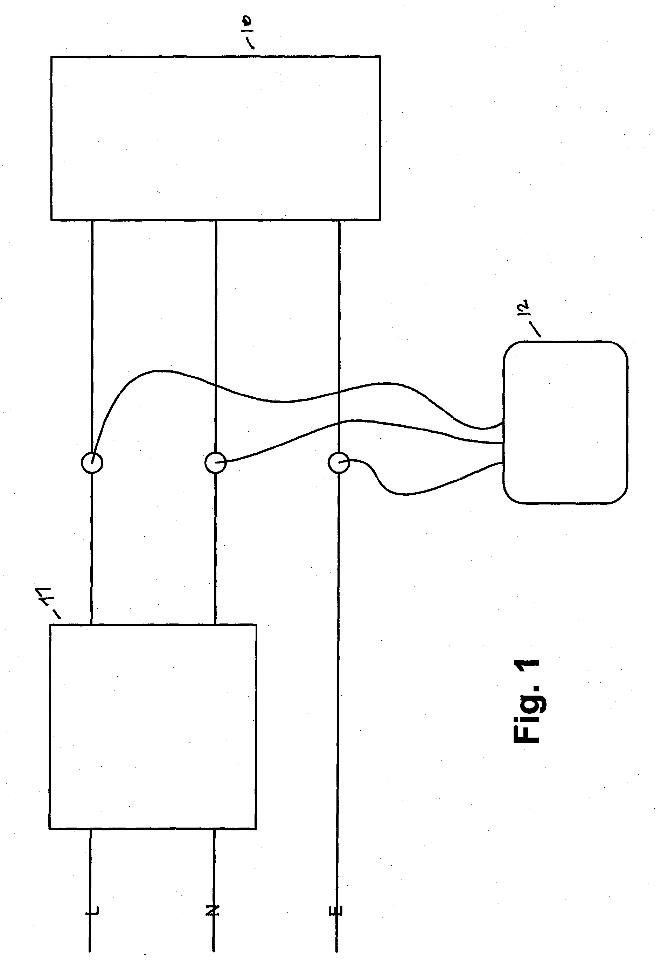

To accomplish detection the live and neutral of the mains electrical supply are each passed through a winding on a common transformer core. These windings are in opposite directions such that if the currents are equal the magnetic flux generated is zero, as the magnetic forces induced cancel each other out. If a leakage current to earth occurs the currents are no longer equal and a magnetic flux flows through the transformer core. A third winding on the core serves to detect any such flux developing a voltage, the amplitude for which is related to the magnitude of the flux. This voltage is monitored and if it exceeds a predetermined threshold it activates a solenoid which in turn trips the set of contacts feeding the live and neutral out of the circuit breaker, thus interrupting the supply. An RCCB of this type is shown in Figure 1.

RCCBs must meet certain standards for safety reasons. It is therefore necessary in any new RCCB installation or up-date, to test the RCCB. Typically, the earth link impedance is tested as is the trip time for the circuit breaker. Typically, the trip time for an RCCB is measured at a number of different current levels. However, it has been observed that measurements of trip time using existing instruments result in inconsistent trip time readings. Although the inconsistent trip time readings typically all fall within the required standard, the inconsistency leads to uncertainty in the minds of operators of the test equipment and their anxiety that the readings they are getting are valid ones. The fact that the tests are performed for reasons of personal safety means that any uncertainty in the validity of the readings can lead to very real anxieties.

The present invention aims to make the testing of RCCBs more consistent.

### Summary of the Invention

According to a first aspect of the present invention there is provided, a device for testing an electric circuit, the electric circuit including a magnetic element, comprising:
means to generate an AC preconditioning signal with decaying amplitude;
means to apply the AC preconditioning signal to the magnetic element;
means to generate a test signal; and
means to apply a test signal to the electric circuit, wherein the device is adapted to apply the test signal subsequent to the preconditioning signal.

Preferably, the device further includes a programmable element and the means to generate an AC preconditioning signal, and the means to generate a test signal are coupled to the programmable element, the programmable element ensuring that upon initiation of a test an AC preconditioning signal with decaying amplitude is applied to the magnetic element prior to the test signal.

Preferably, the amplitude of the preconditioning signal decays to zero.

Preferably, the device is a residual current circuit breaker (RCCB) trip time test instrument. Typically, RCCBs include a transformer core onto which live and neutral windings are placed. The live and neutral windings are identical to each other but wound in the opposite sense to one another. Accordingly, if the current in the live and neutral is equal there will be no magnetic field induced in the transformer core. However, if the live and neutral currents are not equal there will be a magnetic field induced in the core. Previous circuit activity, such as loop impedance tests, can leave the transformer core magnetised even after the live and neutral currents have returned to an equal condition. This can affect subsequent tests. The device of the present invention applies a pre-conditioning decaying AC signal to the transformer core in order to bring the residual magnetism to within a specified, acceptable level.

The device of the present invention is not restricted to RCCBs. Other circuits that use transformers or other magnetic elements may have their performance affected by residual magnetism. By pre-conditioning the magnetic element prior to performing any test on the circuit a more reliable and consistent measurement can be ensured.

According to a second aspect of the invention, there is provided a method for testing an electric circuit including a magnetic element, comprising the steps of:
pre-conditioning the magnetic element by applying an AC preconditioning signal with a decaying amplitude across the magnetic element; and
subsequently testing the electrical circuit.

Preferably, the step of preconditioning the magnetic element comprises applying a low frequency AC signal of predetermined initial amplitude such that the AC signal saturates the magnetic element. Preferably, the low frequency AC signal is in the range of 1 to 10Hz. The frequency is so low that large current is not detected by the sensory winding and in the RCD and so the RCD does not trip.

The step of testing the electrical circuit may comprise applying multiple test signals to the electric circuit. In this case, the step of applying a pre-conditioning AC signal may be performed before each test signal is applied or alternatively may be performed before any sum of the test signals are applied.

### Brief Description of the Drawings

Examples of the present invention will now be described with reference to the accompanying drawings, in which:
Figure 1 is a schematic illustration of an electrical installation including a residual current circuit breaker (RCCB);
Figure 2 illustrates a section of the RCCB circuit of Figure 1;
Figure 3 is a schematic diagram of a testing instrument in accordance with the present invention; and,
Figure 4 is a flow chart showing the steps performed in accordance with one example of the method of the present invention.

### Detailed Description

Figure 1 is a schematic illustration, such as a domestic building. The installation 10 is connected to single phase mains supply. The mains supply has a live, a neutral, and an earth wire, indicated as L, N and E respectively. A residual current circuit breaker (RCCB) 11 is connected to the live and neutral wires. If the difference between the current flowing in the live wire and the current flowing in the neutral wire exceeds a certain threshold, the RCCB will "trip", interrupting the power supplied to the installation.

Figure 1 also shows a testing instrument 12 attached to the live, neutral and earth wires. The test instrument may be designed to test the earth for impedance or to measure the trip time of the RCCB for example.

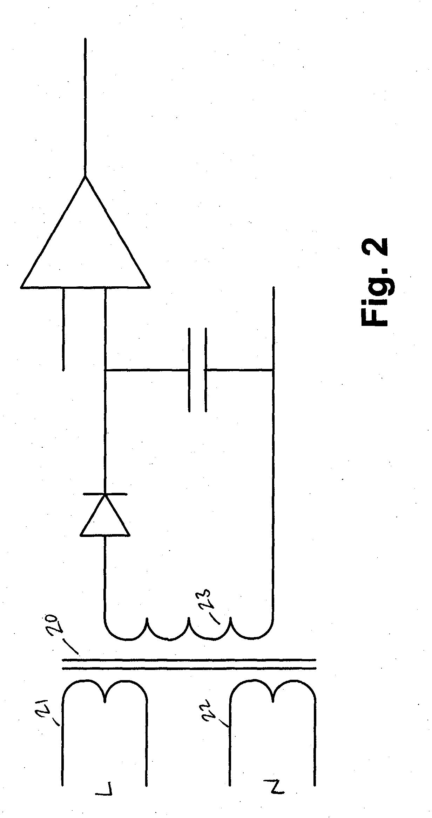

Figure 2 is a circuit diagram of a section of the RCCB of Figure 1. The RCCB includes a magnetic core 20 onto which a section of the live wire 21 is wound. An identical section of the neutral wire 22 is also wound on the core, but in the opposite sense. If the currents through the live and neutral wires are equal the magnetic flux induced by the windings will cancel each other out. If there is a current imbalance between the live and neutral then a magnetic flux will result. A third winding 23 is placed on the core in order to detect any magnetic flux. A magnetic flux will induce a voltage in the third winding. The amplitude of the induced voltages related to the current difference between the live and neutral. The level of the induced voltage is compared with the reference voltage using a comparator, after passing through a rectifier. If the induced voltage exceeds the reference voltage a solenoid is activated which trips a set of contacts feeding the live and neutral out of the RCCB.

In order to meet safety standards, the time it takes for the RCCB to trip out the power supply for a given current imbalance must be less than a certain time. The trip time is different for different current imbalances because the capacitor in the RCCB circuit must charge up before the threshold voltage is reached. At higher currents the capacitor will charge up more quickly. In non-electronic RCCBs the influence of current on tripping time may be more severe since the power to drive the solenoid is drained from the imbalanced current.

Typically, in order to test that the RCCB trip time is fast enough, a number of different currents are applied to the live wire. Firstly, a short pulse current signal is applied. The pulse is used to confirm that the RCCB has a good earth and that the earth voltage is not raised to a dangerous level when the test current is applied. The RCCB is tested with a current of ½I_{Δn}· I_{Δn} is defined as the current imbalance that produces the threshold voltage. This is typically 30 milliamps for safety reasons. The ½I_{Δn} signal tests whether the RCCB is too sensitive. If the RCCB trips at a ½I_{Δn} then the RCCB is too sensitive and is therefore defective. The RCCB is then tested at I_{Δn} to check how long it takes to trip. At I_{Δn} the RCCB should trip out in less than a predetermined time, in this example 100 milliseconds. The RCCB is also tested at 5 I_{Δn} and in this example at this current the trip time should be less than 40 milliseconds.

The test currents used are conveniently AC currents at the mains frequency, i.e. 50 Hz in Europe. One cycle of the mains is therefore 20 milliseconds. It has been noted that with existing testers there is often an inconsistency of 20 milliseconds between what should be identical measurements. This is partly due to residual magnetism on the transformer core as explained below. If there is residual magnetism on the core the trip time might be increased by one cycle or reduced by one cycle depending on the polarity of the test signal. As described above, a sequence of different current signals are used to test the RCCB trip time. Furthermore, a loop impedance test is often performed prior to the trip time test. Each of these multiple test signals can leave the transformer core in a magnetised state.

Residual magnetism on the transformer core can affect the magnitude of the voltage induced as a result of a current imbalance. This is due to the B-H hysteresis/saturation characteristics of the transformer core. Residual magnetism on the core can leave the core in a non-linear region of the hysteresis curve, i.e. a state in which the relationship between current imbalance and induced voltage is not linear. This will result in the induced voltage being less than expected.

It will not be known how much residual magnetism is on the transformer core prior to a test. However, owing to the shape of hysteresis curve, the application of a decaying AC signal to one of the live or neutral windings will bring the residual magnetism to within an acceptable (linear) range. The decaying AC signal has a low frequency, in the range of 1 to 10 Hz, so that it does not trip the RCCB. The decaying AC signal also has an initial amplitude which is large enough to saturate the core whatever the residual magnetism. The AC signal can be sinusoidal, sawtooth shaped or any other profile. The initial amplitude, i.e. the first cycle, saturates the core. The amplitude of successive cycles slowly drops until it reaches a point when the amplitude is just enough to saturate the core. At this point the oscillating current will cause the magnetism to oscillate symmetrically about zero flux. As a result, as the amplitude of the current signal decays to zero the core will be left in an unmagnetised state. It is preferred that the decaying AC signal takes at least 5 cycles before it's amplitude is reduced to zero. As long as the magnetism returns to within the linear range of the hysteresis curve repeatable results can be obtained.

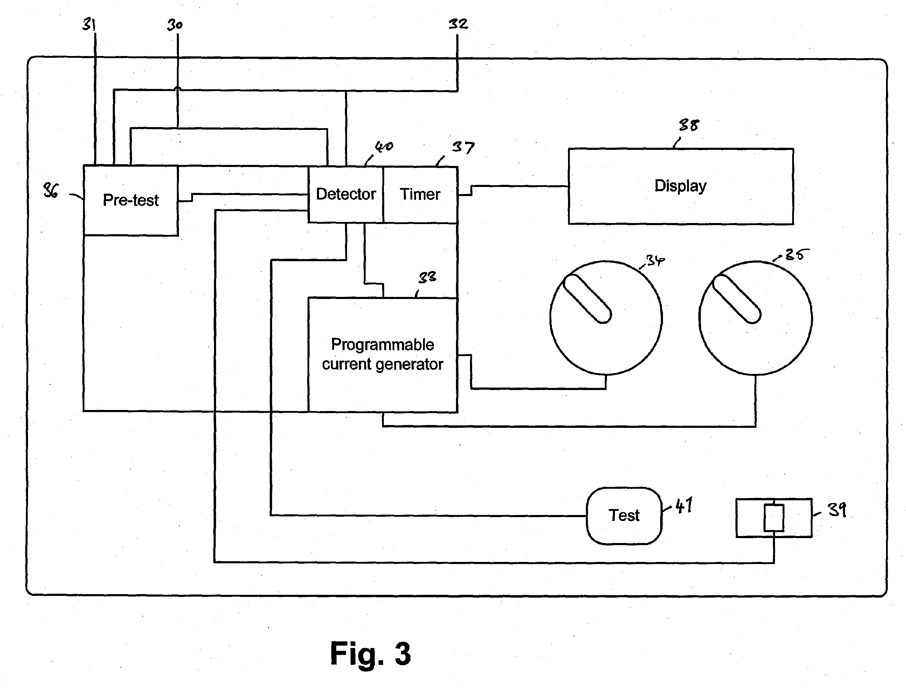

Figure 3 is a schematic illustration of a device in accordance with the present invention. The device shown in Figure 3 is an RCCB trip time tester. The trip time tester uses a sequence of applied currents as described above. The device includes three output leads 30, 31, 32 for connection to the live, neutral and earth wires and also includes a programmable current generator 33, or programmable element coupled to a signal generator, for generating the test currents required. The programmable current generator 33 also produces a decaying AC preconditioning signal prior to testing. Two dials are provided for selecting the test current. The first dial 34 is used to select I_{Δn} which may be different for different RCCBs. The second dial 35 is a scaling dial, so that ½I_{Δn}, I_{Δn} and 5I_{Δn} can be selected. The device also includes a pre-test signal generation means 36 for producing a short pre-testing pulse. The device applies the test signals across the RCCB and measures the trip time. The device includes a timer device 37 for recording the trip time and a time display 38 which displays the trip time to the operator. The test signals can be selected to start at zero phase or 180° phase by a phase switch 39. Detector 40 tests for a satisfactory short earth pre-test pulse result, synchronises the test current with the test phase selected on phase switch 39, and monitors the live/neutral voltage to detect RCCB tripping. The display 38 shows the result. Also shown is the test button 41 which is used to initialise a test.

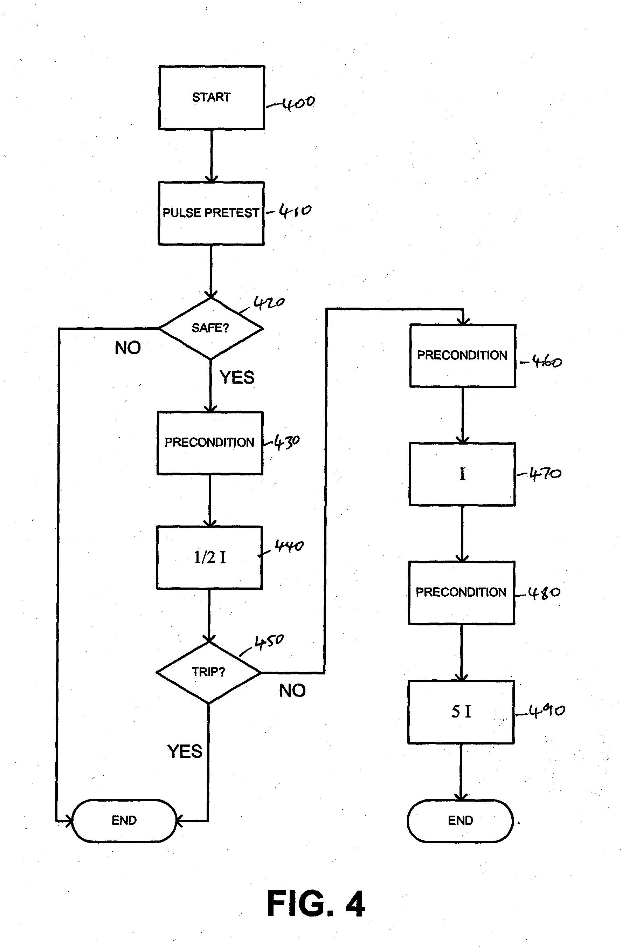

Figure 4 is a flow chart showing the process steps in a testing operation in accordance with the present invention. The test is started at step 400 and a pre-test pulse is applied at step 410. The pre-test pulse is as described above a short pulse which does not trip the RCCB but allows the operator to check that the earth loop impedance falls within a safe limit. If the earth loop impedance is safe the test continues. If it is not then the test is ended. This is indicated by decision box 420. The operatorwill then select the ½I_{Δn} test and activate the test button. The test device then applies a pre-conditioning decaying AC signal to the RCCB at step 430 followed by the ½I_{Δn} test at step 440. If the RCCB trips at the ½I_{Δn} current then the test is aborted at step 450 as the RCCB is defective. If the RCCB does not trip in this time then the next stage of the test can be performed. The operator then turns the dial to the I test and activates the test button again. The device automatically pre-conditions the RCCB circuit by applying the AC signal with the decaying amplitude again at step 460 followed by the I_{Δn} signal at step 470. The trip time at I_{Δn} is recorded and displayed on the time display. The operator will then select the 5I test. The device pre-conditions the RCCB circuit again using the decaying AC signal at step 480 followed by the 5I_{Δn} signal at step 490. Again the trip time is displayed on the display and the test is ended. The operator will record the trip time for I_{Δn} and 5I_{Δn} and check that they are within the acceptable range.

In the example of Figure 4, a pre-conditioning signal, comprising a decaying amplitude AC signal, is applied prior to each test signal. The pre-conditioning signal may be applied prior to each test signal or alternatively may be applied only prior to the I and 5I_{Δn} tests, i.e. at step 460.

The present invention has been described with reference to a transformer core in an RCCB circuit. However, the present invention applies to the preconditioning of any magnetic elements in circuits which are to be tested.

## Claims

1. A device for testing an electric circuit, the electric circuit including a magnetic element, comprising:
means to generate an AC preconditioning signal with decaying amplitude;
means to apply the AC preconditioning signal to the magnetic element;
means to generate a test signal; and
means to apply a test signal to the electric circuit, wherein the device is adapted to apply the test signal subsequent to the preconditioning signal.

2. A device according to claim 1, further including a programmable element, wherein the means to generate an AC preconditioning signal and the means to generate a test signal are coupled to the programmable element, the programmable element ensuring that upon initiation of a test an AC preconditioning signal with decaying amplitude is applied to the magnetic element prior to the test signal.

3. A device according to claim 1 or 2, wherein the amplitude of the preconditioning signal decays to zero.

4. A device according to any preceding claim, wherein the device is a residual current circuit breaker (RCCB) trip time test instrument.

5. A method for testing an electric circuit including a magnetic element, comprising the steps of:
pre-conditioning the magnetic element by applying an AC preconditioning signal with a decaying amplitude across the magnetic element; and
subsequently testing the electrical circuit.

6. A method according to claim 5, wherein the step of pre-conditioning the magnetic element comprises applying an AC signal of a predetermined initial amplitude such that the AC signal saturates the magnetic element.

7. A method according to claim 5 or 6, wherein the step of testing the electrical circuit comprises applying multiple test signals to the electric circuit.

8. A method according to claim 7, wherein the step of applying a pre-conditioning AC signal is performed before each test signal is applied.
